# EUROPEAN PATENT APPLICATION

(11) **EP 4 550 403 A1**
(43) Date of publication of application: **07.05.2025**
(21) Application number: 23206951.8
(22) Date of filing: 31.10.2023
(51) Int. Cl.: H01L 23/31, H01L 23/495

(54) **A METHOD FOR MANUFACTURING A SEMICONDUCTOR PACKAGE ASSEMBLY AS WELL AS SUCH SEMICONDUCTOR PACKAGE ASSEMBLY**

(71) Applicant: Nexperia B.V., 6534 AB Nijmegen (NL)
(72) Inventor: Brown, Adam, Manchester, SK7 5BJ (GB); Ting, Jia Yunn, Seremban (MY); Chang, Ting Wei, Seremban (MY)
(74) Representative: Pjanovic, Ilija

(57) **Abstract**

A method for manufacturing a semiconductor package assembly, the method comprising: after a Die Attach Clip Attach, DACA, process (102) on a semiconductor package, performing a flux cleaning treatment process (104) wherein exposed surfaces of the semiconductor package are cleaned; performing a surface roughening treatment process (108) wherein the exposed surfaces are roughened, wherein the surface roughening treatment process (108) is performed separately from the flux cleaning treatment process (104); and after performing the surface roughening treatment process (108), encapsulating (112) the semiconductor package with a moulding resin, thereby forming the encapsulated semiconductor package assembly.

## Description

### Technical field

The present disclosure relates to a method for manufacturing a semiconductor package assembly including a semiconductor package and an encapsulation encapsulating the semiconductor package. The disclosure also relates to a semiconductor device and semiconductor package assembly manufactured using the method.

### Background

High-power semiconductor package assemblies are known to be more sensitive to moisture ingression and ionic contaminations which are induced by delamination. For obtaining a robust high-power semiconductor package assembly, delamination of the moulding resin case from the semiconductor package has to be avoided.

Accordingly, preventing or limiting the occurrence of delamination in a semiconductor package assembly can be improved by enhancing the adhesion between the semiconductor package and the moulding resin, e.g., Epoxy Moulding Compound (EMC), and reducing mechanical stress during the assembly process. In enhancing the adhesion aspect, surface morphology of the semiconductor package can limit the effect of delamination and this is commonly achieved by roughening the lead frame.

Roughening the surface of the lead frame is commonly executed at the supplier site, yet one of the disadvantages are costs, which is higher due to additional etching and finishing process. In addition, roughened surfaces may cause negative impact on solder wettability issues and pattern recognition (PR) issues in Die Attach Clip Attach (DACA) processes.

### Summary

A summary of aspects of certain examples disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

The present disclosure provides a method of manufacturing a semiconductor package assembly as well as a semiconductor package (also referred to as semiconductor device) and a semiconductor package assembly manufactured using such method. An improved adhesion between the semiconductor package and the moulding resin case encapsulating the semiconductor package may be achieved and effects of delamination may be significantly reduced.

According to an aspect of the present disclosure, a method of manufacturing a semiconductor package assembly is presented. The method may include, after a DACA process on a semiconductor package, performing a flux cleaning treatment process wherein exposed surfaces of the semiconductor package are cleaned. The method may further include performing a surface roughening treatment process wherein the exposed surfaces are roughened. The surface roughening treatment process may be performed separately from the flux cleaning treatment process. The method may further include, after performing the surface roughening treatment process, encapsulating the semiconductor package with a moulding resin, thereby forming the encapsulated semiconductor package assembly.

In an embodiment, the flux cleaning treatment process may be performed before and separately from the surface roughening treatment process.

In another embodiment, the flux cleaning treatment process may be performed after and separately from the surface roughening treatment process.

In an embodiment, the DACA process may include providing a lead frame having a first frame side and a second frame side opposite to the first frame side. The DACA process may further include adhering at least one semiconductor die structure having a first die side and a second die side opposite to the first side with its second die side on the first frame side of the lead frame, resulting in a first conductive connection between the lead frame and the at least one semiconductor die structure. The DACA process may further include adhering at least one bond element on the first die side of the at least one semiconductor die structure and/or on the first frame side of the lead frame, resulting in at least one further conductive connection between the at least one bond element and the at least one semiconductor die structure and between at least a further bond element and the lead frame.

In an embodiment, the surface roughening treatment process may include a copper etching using a copper etchant.

In an embodiment, the copper etchant does not include a photoresist layer stripping agent.

In an embodiment, the surface roughening treatment process may include submerging the semiconductor package in a chemical etching solution for a period of less than 10 minutes, e.g., less than 1 minute.

In an embodiment, the flux cleaning treatment process may be followed by a first rinsing process of rinsing the semiconductor package with deionized water. After the first rinsing process, a first drying process of drying the semiconductor package may be performed.

In an embodiment, the surface roughening treatment process may be followed by a second rinsing process of rinsing the semiconductor package with deionized water. After the second rinsing process, a second drying process of drying the semiconductor package may be performed.

In an embodiment, the encapsulating may be followed by plating the exposed lead frame. The plating may be followed by singulating the encapsulated semiconductor package assembly.

According to an aspect of the present disclosure, semiconductor device is presented. The semiconductor device, which is also referred to as semiconductor package, may be obtained using the method having one or more of the above described features. The semiconductor device may include one or more roughened surfaces obtained by a surface roughening treatment process wherein exposed surfaces are roughened separately from a flux cleaning treatment process.

According to an aspect of the present disclosure, a semiconductor package assembly is presented. The semiconductor package assembly may include one or more semiconductor devices having one or more of the above described features. The semiconductor package assembly may further include an encapsulation encapsulating the one or more semiconductor devices.

### Brief description of the Drawings

Embodiments of the present disclosure will now be described, by way of example only, with reference to the accompanying schematic drawings in which corresponding reference symbol indicate corresponding parts, in which:
Fig. 1 shows a flow chart depicting steps of an example method according to the disclosure;
Fig. 2A and Fig. 2B show two examples of more detailed flow charts depicting steps of a method according to the disclosure;
Fig. 3 and Fig. 4 are two examples showing details of a semiconductor package assembly as may be obtained with the method according to the disclosure.

The figures are intended for illustrative purposes only, and do not serve as restriction of the scope of the protection as laid down by the claims.

### Detailed description

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure but is merely representative of various embodiments. While the various aspects of the embodiments are presented in drawings, the drawings are not necessarily drawn to scale unless specifically indicated.

The described embodiments are to be considered in all respects only as illustrative and not restrictive. The scope of the present disclosure is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present disclosure should be or are in any single example of the present disclosure. Rather, language referring to the features and advantages is understood to mean that a specific feature, advantage, or characteristic described in connection with an embodiment is included in at least one embodiment of the present disclosure. Thus, discussions of the features and advantages, and similar language, throughout this specification may, but do not necessarily, refer to the same example.

Furthermore, the described features, advantages, and characteristics of the present disclosure may be combined in any suitable manner in one or more embodiments. One skilled in the relevant art will recognize, in light of the description herein, that the present disclosure may be practiced without one or more of the specific features or advantages of a particular embodiment. In other instances, additional features and advantages may be recognized in certain embodiments that may not be present in all embodiments of the present disclosure. Reference throughout this specification to "one embodiment," "an embodiment," or similar language means that a particular feature, structure, or characteristic described in connection with the indicated embodiment is included in at least one embodiment of the present disclosure. Thus, the phrases "in one embodiment," "in an embodiment," and similar language throughout this specification may, but do not necessarily, all refer to the same embodiment.

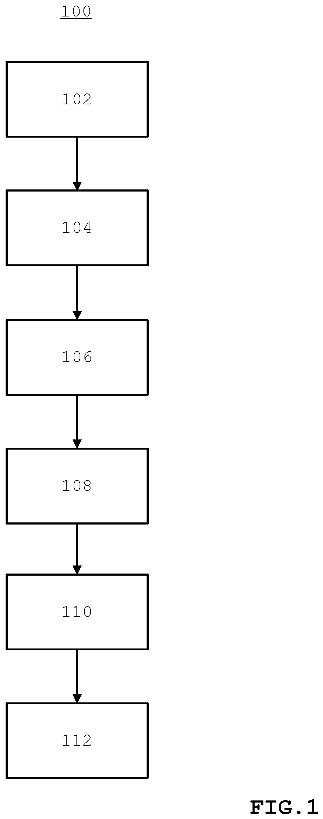

Delamination of mould compound from moulded semiconductor devices may be prevented or limited by roughening exposed copper surfaces before moulding. An improved method 100 of manufacturing a semiconductor package assembly wherein exposed copper surfaces are roughened before moulding is shown in Fig. 1.

After standard DACA process 102, leadframes, typically made from copper, may subjected to a flux cleaning treatment 104 typically followed by a rinse step 106. Next, the leadframes may be roughened in a surface roughening treatment step 108, e.g., by performing a copper etching, where the leadframes may receive a quick dip process in a standard copper etch chemical. After the roughening in step 108, the leadframes may be rinsed again in step 110. Step 112 depicts a moulding process resulting in an encapsulated semiconductor package.

The order of performing the flux cleaning treatment 104 and the surface roughening treatment 108 may be reversed.

Different from known roughening processes, in the method of the present disclosure the roughening process 108 is separate from the flux clean 104. Advantageously, this results in a more cost-effective process, as cheaper chemicals may be used for the method 100 of the present disclosure. For example, a low cost dedicated flux-cleaner may be used in the flux cleaning step 104 and a low cost copper etchant may be used in the roughening step 108.

Furthermore, the process becomes less dependent on the copper etchant used, i.e., compared to known processes where flux cleaning and roughening are performed in a single step requiring specialized combined flux cleaning and roughening chemicals, the etching process of the present disclosure is not single sourced and multiple vendors of copper etchants may be used.

The method of the present disclosure is fully compatible with silicon wafers; copper etchant is common in front-end fabs and highly selective against other layers on wafers. The method 100 is, e.g., compatible to Ti, oxide, nitride, Si, Ni and Pb-free solders, with excellent selectivity to silicon MOSFET wafer layers such as Ti, Ni, Ag, Si, SiN and SiO.

Another advantage of the method of the present disclosure is that the process is faster. Where a known process wherein flux cleaning and roughening are performed in one step may take about 30 minutes or more to etch 40nm copper, in the process of the present disclosure the copper etchants may etch 108 such thickness in about 10 seconds. Note that the separated flux cleaning step 104 is also a relatively quick procedure, compared to the known combined process.

Moreover, the chemicals used in the process of the present disclosure, e.g., the flux cleaning chemicals used in steps 104 and the etching chemicals used in step 108, may be more environmentally friendly compared to chemicals used in the known combined flux cleaning and roughening.

Other known lead frame roughening methods, particularly for copper (Cu) lead frames, use chemical etching which consists of acids like H₂SO₄, H₂O₂ or a mixture of it. These acids are etchant and potentially etch/attack the die top metal, typically AICu/TiNiAg, which may eventually cause poor contact and reliability issue. The solution of the present disclosure may use chemicals that are generally safe/compatible with the die structure and typically do not attack the die top metal/surface, while the etchant used in step 108 may have substantial roughening effect to the lead frame surface and interconnects.

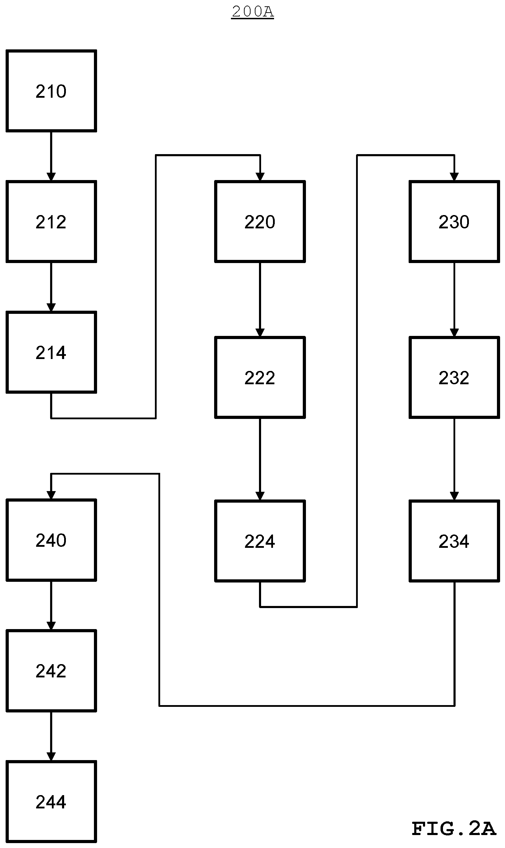

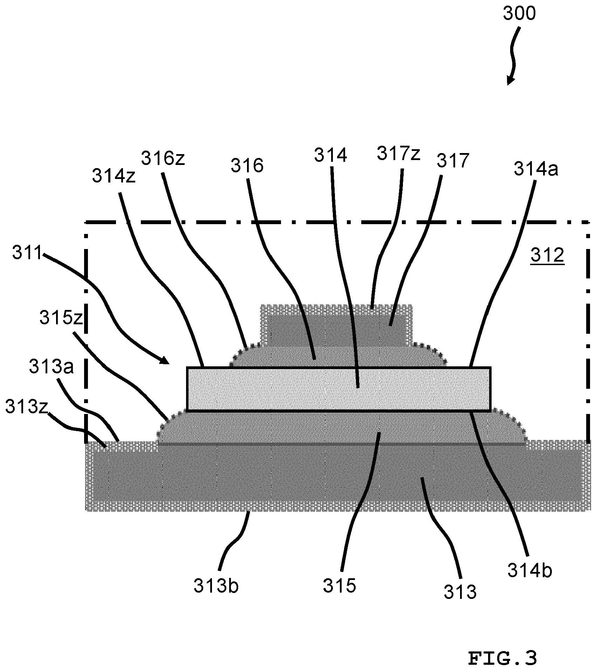

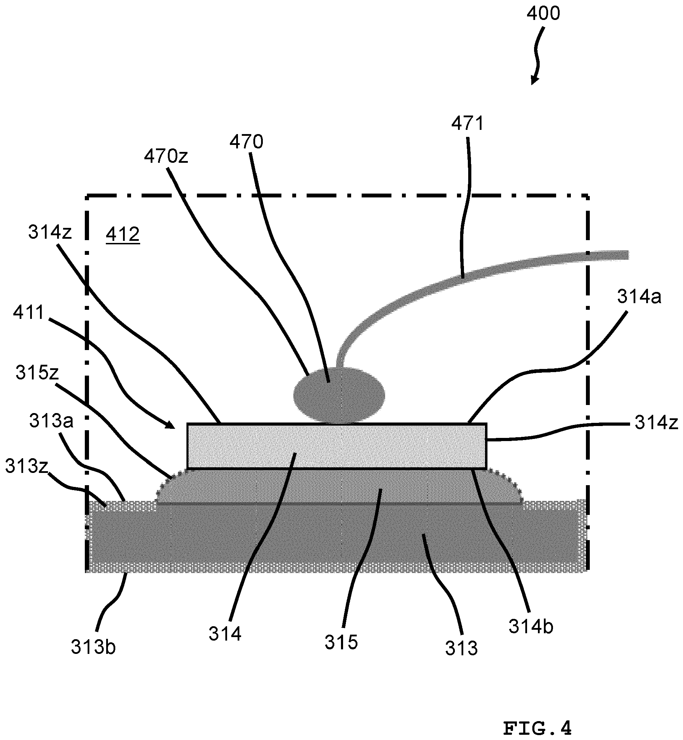

In Fig. 2A a more detailed flow chart 200A is shown of an example method of manufacturing a semiconductor package assembly. In the following description of Fig. 2A, references are made to example semiconductor package assemblies 300, 400 shown in Fig. 3 and Fig. 4, respectively.

In the example of Fig. 2A, in a first steps at least one semiconductor package (reference numeral 311 in Fig. 3, 411 in Fig. 4) may be formed by means of the sub-steps 210 providing a lead frame 313 having a first frame side 313a and a second frame side 313b opposite to the first frame side 313a. The semiconductor package 311, 411 may be referred to as semiconductor device. The lead frame 313 is preferably made from a copper material plate. Following the sub-step 210, in a sub-step 212 at least one semiconductor die structure 314 may be adhered to the lead frame 313. In general at least one semiconductor die structure 314 may have a first die side 314a and a second die side 314b opposite to the first side 314a and the adhering step 212 may be performed by adhering the second die side 314b on the first frame side 313a of the lead frame 313.

The adhering step 212 may be performed with any suitable adhering principle used in semiconductor package manufacturing. For example, a glue connection or a soldering connection can be implemented, as long as step 212 results in a first conductive connection 315 between the lead frame 313 and the at least one semiconductor die structure 314.

Similarly, in a further adhering step 214 at least one bond element may be adhered on the first die side 314a of the at least one semiconductor die structure 314 and/or on the first frame side 313a of the lead frame 313. Likewise, in step 214, any suitable adhering principle may be used in semiconductor package manufacturing, such as a glue connection or a soldering connection. In either way, also step 214 may results in at least one further conductive connection 316 between the at least one bond element and the at least one semiconductor die structure 314 and between at least a further bond element and the lead frame 313. As to the type of bond element used, in an example of step 214, a bond clip 317 (Fig. 3) may be adhered to the semiconductor die structure 314 thus forming the further conductive connection 316, whereas in Fig. 4, the result of step 214 may be a further conductive connection being formed of a contact pad or ball bond 470 adhered to the first die side 314a of the semiconductor die structure 314, further completed with the adhering of a bond wire 471 to the contact pad or ball bond 470.

After establishing the conductive connections 315 and 316, the encapsulated semiconductor package assembly 300, 400 may be created in step 240 by encapsulating the at least one semiconductor package 311, 411 with a moulding resin case 312, e.g., an EMC, or any other suitable encapsulation.

In order to prevent or limit the occurrence of delamination in the semiconductor package assembly 300, 400 between the moulding resin (e.g., EMC) and the semiconductor package 311, 411 the adhesion between both parts of the semiconductor package assembly 300, 400 may be improved and according to the present disclosure steps 220-232 are presented.

In steps 220-234, the exposed surface 313z of the first frame side 313a of the lead frame 313, the exposed surfaces 315z, 316z of the adhering conductive connections 315, 316, the exposed surface 314z of the semiconductor die structure 314 and the exposed surfaces 317z, 470z of the bond elements 317, 470 of the at least one semiconductor package 311-411 are subjected to a flux cleaning treatment 220 and a separate surface roughening treatment 230.

The flux cleaning treatment step 220 may be performed prior to the surface roughening treatment step 230, but after the adhering step 214 of adhering the at least one bond element 317, 470, 471 on the first die side 314a of the at least one semiconductor die structure 314 and/or on the first frame side 313a of the lead frame 313. The surface roughening treatment step 230 may be performed prior to the moulding related steps 240-244, but after the flux cleaning treatment step 220.

Alternatively, it is also noted that the step 214 of adhering the bond wire 471 to the contact pad or ball bond 470 may be performed before or after the roughening treatment step 230. The roughening of a bond wire 471 is only applicable if the wire bonding step is performed before the etching in step 230.

The flux cleaning treatment 220 may be followed by a rinsing step 222, e.g., using deionized water, and a drying step 224 before applying the roughening treatment in step 230. The roughening treatment step 230 may be followed by a rinsing step 232 e.g., using deionized water, and a drying step 234 before starting the moulding related steps 240-244.

With the surface roughening treatment of step 230 all outer surfaces 313z, 314z, 315z, 316z, 317z, 470z of the complete semiconductor package 311, 411 may undergo a surface roughening treatment prior to its encapsulation, e.g., with the EMC moulding resin case 312. The overall adhesion with the moulding resin (e.g., EMC) 312 is thus significantly improved and any risk of delamination between (the outer surface of) the semiconductor package 311, 411 and the EMC 312 may be reduced. Also, the adverse effects of surface roughening of the lead frame 313 in advance at the supplier site are obviated as well as its corresponding negative impact on solder wettability issues and PR issues in DACA processes.

The chemical solution used in step 220 may be an organic or inorganic cleaning agent. The chemical solution used in step 230 may be a copper etchant. The copper etchant need not be able to strip photoresist.

After the encapsulating step 240, the method may include step 242 of plating the exposed lead frame ends and singulating in step 244 the at least one encapsulated semiconductor package assembly, thereby obtaining a single encapsulated semiconductor package assembly 310, 410 with a moulding resin case 312 having an improved adhesion with the roughened yet encapsulated semiconductor package 311, 411 and consequently a reduced risk of delamination.

Steps 210-214 of Fig. 2A may correspond to step 102 of Fig. 1. Step 220 of Fig. 2A may correspond to step 104 of Fig. 1. Steps 222-224 of Fig. 2A may correspond to step 106 of Fig. 1. Step 230 of Fig. 2A may correspond to step 108 of Fig. 1. Steps 232-234 of Fig. 2A may correspond to step 110 of Fig. 1. Steps 240-244 of Fig. 2A may correspond to step 112 of Fig. 1.

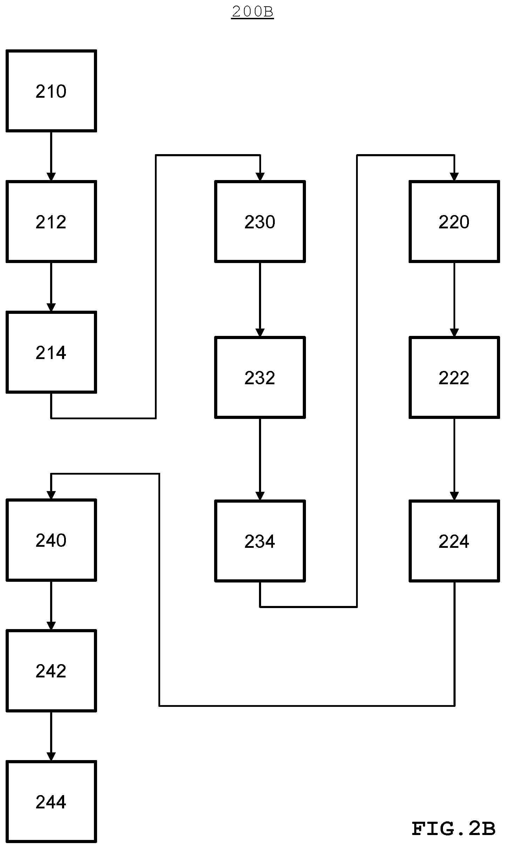

The order of processing the flux cleaning related steps 220-224 and the surface roughening relates steps 230-234 may be reversed. An example hereof is shown in the example flowchart 200B of Fig 2B. The individual steps of the flowchart 200B may be similar or identical to the steps of the flowchart 200A.

Fig. 3 and Fig. 4 show two examples of a semiconductor package assembly as may be obtained with the method 100, 200A, 200B according to the present disclosure. These examples are denoted with reference numeral 300 (Fig. 3) and 400 (Fig. 4), respectively. The semiconductor package assemblies 300, 400 as shown in Fig. 3 and Fig. 4 may be conventional lead frame-based integrated circuit (IC) package assemblies. The main part is the semiconductor package, indicated with reference numeral 311 in Fig. 3 and reference numeral 411 in Fig. 4.

In an example, the semiconductor package 311, 411 may include a lead frame 313 having a first frame side 313a and a second frame side 313b, the latter being positioned opposite to the first frame side 313a. The first frame side 313a may be classified as the upper or top side, whereas the second frame side 313b opposite to the first frame side 313a may be classified as the bottom or lower side. In the examples of Fig. 3 and Fig. 4, the lead frame 313 may be made from a copper plate material.

Reference numeral 314 denotes a semiconductor die structure having a first (top or upper) die side 314a and a second (bottom or lower) die side 314b opposite to the first side 314a. The semiconductor die structure 314 may be provided or mounted with its lower, second die side 314b on the upper, first frame side 313a of the lead frame 313. The mounting may be facilitated by means of an adhering connection, e.g. a glue connection or a soldering connection 315, which, during manufacturing, as outlined in step 212 of the method 200A, 200B, may be provided between the lower, second die side 314b and the upper, first frame side 313a.

In both examples of Fig. 3 and Fig. 4, conformal to step 214 of the method 200A, 200B, one or more bond elements may be electrically connecting the semiconductor die structure 314 with, e.g., the lead frame 313. Accordingly, as shown in Fig. 3, the semiconductor die structure 314 may be on its first (top or upper) die side 314a provided with one or more bond elements 317, which may be construed as bond clips 317. The bond clips 317 in this example may be provided on the upper, first die side 314a with the assistance of the adhering connection 316, e.g. through gluing or soldering.

Alternatively, as shown in Fig. 4, one or more bond wires 471 may be electrically connected via a contact pad or ball bond 471 with the first die side 314a of the semiconductor die structure 314 using suitable known semiconductor connecting techniques. Each bond wire 471 may be electrically connected with a frame lead (not shown) of the lead frame 313.

When performing the surface roughening treatment of step 230, all exposed outer surfaces 313z, 314z, 315z, 316z, 317z, 470z of the first frame side 313a of the lead frame 313, the adhering conductive connections 315, 316, the semiconductor die structure 314 and the bond elements 317-470 of the at least one complete semiconductor package 311, 411 may be surface roughened prior to their encapsulation with the moulding resin case 312 or any other suitable encapsulation.

## Claims

1. A method (100, 200A, 200B) of manufacturing a semiconductor package assembly (300, 400), the method comprising:
after a Die Attach Clip Attach, DACA, process (102, 210-214) on a semiconductor package (311, 411), performing a flux cleaning treatment process (104, 220) wherein exposed surfaces of the semiconductor package (311, 411) are cleaned;
performing a surface roughening treatment process (108, 230) wherein the exposed surfaces are roughened, wherein the surface roughening treatment process (108, 230) is performed separately from the flux cleaning treatment process (104, 220); and
after performing the flux cleaning treatment process (104, 220) and the surface roughening treatment process (108, 230), encapsulating (112, 240) the semiconductor package (311, 411) with a moulding resin, thereby forming the encapsulated semiconductor package assembly (300, 400).

2. The method according to claim 1, wherein the flux cleaning treatment process (104, 220) is performed before and separately from the surface roughening treatment process (108,230).

3. The method according to claim 1, wherein the flux cleaning treatment process (104, 220) is performed after and separately from the surface roughening treatment process (108,230).

4. The method according to any one of the preceding claims,
wherein the DACA process (102, 210-214) comprises:
providing (210) a lead frame having a first frame side and a second frame side opposite to the first frame side;
adhering (212) at least one semiconductor die structure having a first die side and a second die side opposite to the first side with its second die side on the first frame side of the lead frame, resulting in a first conductive connection between the lead frame and the at least one semiconductor die structure; and
adhering (214) at least one bond element on the first die side of the at least one semiconductor die structure and/or on the first frame side of the lead frame, resulting in at least one further conductive connection between the at least one bond element and the at least one semiconductor die structure and between at least a further bond element and the lead frame.

5. The method according to any one of the preceding claims, wherein the surface roughening treatment process (108, 230) comprises a copper etching using a copper etchant.

6. The method according to claim 5, wherein the copper etchant does not include a photoresist layer stripping agent.

7. The method according to any one of the preceding claims, wherein the surface roughening treatment process (108, 230) comprises submerging the semiconductor package in a chemical etching solution for a period of less than 10 minutes, in particular less than 1 minute.

8. The method according to any one of the preceding claims, wherein the flux cleaning treatment process (104, 220) is followed by:
a first rinsing process (106, 222) of rinsing the semiconductor package with deionized water; and
a first drying process (224) of drying the semiconductor package.

9. The method according to any one of the preceding claims, wherein the surface roughening treatment process (108, 230) is followed by:
a second rinsing process (110, 232) of rinsing the semiconductor package with deionized water; and
a second drying process (234) of drying the semiconductor package.

10. The method according to any one of the preceding claims, wherein the encapsulating (112, 240) is followed by:
plating (242) the exposed lead frame; and
singulating (244) the encapsulated semiconductor package assembly.

11. A semiconductor device (311, 411) obtained using the method (100, 200A, 200B) according to any one of the claims 1-10, the semiconductor device comprising:
one or more roughened surfaces obtained by a surface roughening treatment process (108, 230) wherein exposed surfaces (313z, 314z, 315z, 316z, 317z, 470z) are roughened separately from a flux cleaning treatment process (104,220).

12. A semiconductor package assembly (300, 400) comprising:
one or more semiconductor devices (311, 411) in accordance with claim 11; and
an encapsulation (312, 412) encapsulating the one or more semiconductor devices (311, 411).
